# EUROPÄISCHE PATENTSCHRIFT

(11) **EP 2 513 982 B1**
(45) Veröffentlichungstag und Bekanntmachung des Hinweises auf die Patenterteilung: **09.11.2016**
(21) Anmeldenummer: 10810959.6
(22) Anmeldetag: 17.12.2010
(51) Int. Cl.: H01L 31/18

(54) **VERFAHREN ZUR HERSTELLUNG EINES DÜNNSCHICHTBAUELEMENTS**
FABRICATION METHOD FOR A THIN-FILM COMPONENT
PROCÉDÉ DE FABRICATION D'UN COMPOSANT À COUCHES MINCES

(30) Priorität: 18.12.2009 DE 102009060922
(43) Veröffentlichungstag der Anmeldung: 24.10.2012
(73) Patentinhaber: Fraunhofer-Gesellschaft zur Förderung der angewandten Forschung e.V., 80686 München (DE)
(72) Erfinder: LASAGNI, Andrés, Fabián Prof. Dr., 01723 Grumbach (DE); DANI, Ines, 09244 Lichtenau (DE)
(74) Vertreter: Pfenning, Meinig & Partner mbB
(86) Internationale Anmeldenummer: PCT/DE2010/001523
(87) Internationale Veröffentlichungsnummer: WO 2011/072663

(56) Entgegenhaltungen:
- WO-A1-2005/053037
- STOCK M L ET AL: "Reliable, High-repetition Rate, Femtosecond, microJoule Fiber Lasers for Precision Applications", PROCEEDINGS OF SPIE, Bd. 5714, 27. Januar 2005 (2005-01-27), Seiten 63-72, XP040200110, DOI: 10.1117/12.598050
- HAUSCHILD D ET AL: "Optimizing laser beam profiles using micro-lens arrays for efficient material processing: applications to solar cells", PROCEEDINGS OF SPIE, Bd. 7202, 28. Januar 2009 (2009-01-28), Seiten 72020U-1-72020U-15, XP040492825, DOI: 10.1117/12.809270
- BOOTH H J: "Recent applications of pulsed lasers in advanced materials processing", THIN SOLID FILMS, Bd. 453-454, 1. April 2004 (2004-04-01), Seiten 450-457, XP004495270, ISSN: 0040-6090, DOI: 10.1016/J.TSF.2003.11.130
- XU M Y ET AL: "F2-laser patterning of indium tin oxide (ITO) thin film on glass substrate", APPLIED PHYSICS A; MATERIALS SCIENCE & PROCESSING, Bd. 85, Nr. 1, 3. August 2006 (2006-08-03) , Seiten 7-10, XP019424441, ISSN: 1432-0630, DOI: 10.1007/S00339-006-3657-2
- NEBEL C E ED - HACK M ET AL: "LASER INTERFERENCE STRUCTURING OF A-SI:H", AMORPHOUS SILICON TECHNOLOGY - 1996. SAN FRANCISCO, CA, APRIL 8 - 12, 1996; [MATERIALS RESEARCH SOCIETY SYMPOSIUM PROCEEDINGS. VOL. 420], PITTSBURGH, PA : MRS, US, Bd. 420, 8. April 1996 (1996-04-08), Seiten 117-128, XP000871547, ISBN: 978-1-55899-323-5
- RODRIGUEZ A ET AL: "Laser interference lithography for nanoscale structuring of materials: From laboratory to industry", MICROELECTRONIC ENGINEERING, Bd. 86, Nr. 4-6, 1. April 2009 (2009-04-01), Seiten 937-940, XP026106314, ISSN: 0167-9317, DOI: 10.1016/J.MEE.2008.12.043 [gefunden am 2009-04-01]
- COCOYER ET AL: "Implementation of a submicrometer patterning technique in azopolymer films towards optimization of photovoltaic solar cells efficiency", THIN SOLID FILMS, ELSEVIER-SEQUOIA S.A. LAUSANNE, CH, Bd. 511-512, 26. Juli 2006 (2006-07-26), Seiten 517-522, XP005444901, ISSN: 0040-6090, DOI: 10.1016/J.TSF.2005.12.017
- EISELE C ET AL: "Periodic light coupler gratings in amorphous thin film solar cells", JOURNAL OF APPLIED PHYSICS, AMERICAN INSTITUTE OF PHYSICS. NEW YORK, US, Bd. 89, Nr. 12, 15. Juni 2001 (2001-06-15) , Seiten 7722-7726, XP012052639, ISSN: 0021-8979, DOI: 10.1063/1.1370996
- SENOUSSAOUI N ET AL: "Thin-film solar cells with periodic grating coupler", THIN SOLID FILMS, ELSEVIER-SEQUOIA S.A. LAUSANNE, CH, Bd. 451-452, 22. März 2004 (2004-03-22), Seiten 397-401, XP004495135, ISSN: 0040-6090, DOI: 10.1016/J.TSF.2003.10.142

## Beschreibung

Die vorliegende Erfindung bezieht sich auf ein Verfahren zur Herstellung eines elektrischen, photoelektrischen, elektrooptischen und/oder optischen Dünnschichtbauelementes. Insbesondere kann es sich bei solchen Dünnschichtbauelementen um Dünnschichtsolarzellen (organisch oder anorganisch) oder um lichtemittierende Elemente (z.B. organische Leuchtdioden) handeln.

Dünnschichtsolarzellen aus amorphem Silizium zeichnen sich durch geringe Herstellungskosten, die Möglichkeit der Fertigung von großflächigen Modulen und der fast unbegrenzten Verfügbarkeit der Ausgangsmaterialien aus. Im Vergleich zu kristallinen SiliziumSolarzellen weisen sie eine deutlich geringere Dicke der aktiven Schicht auf (einige Mikrometer gegenüber etwa 200 µm). Für Dünnschichtsolarzellen sind dünnere Schichten aus amorphem Silizium nicht nur hinsichtlich einer kurzen Beschichtungszeit interessant, sie zeigen auch eine geringere Degradation (das heißt eine geringere zeitliche Abnahme des Wirkungsgrades). Nachteilig bei den dünnen amorphen Siliziumschichten ist jedoch die geringere Lichtausnutzung durch die relativ geringe Absorption.

Um trotzdem einen hohen Wirkungsgrad zu erzielen wird angestrebt, durch eine Oberflächenstrukturierung die Weglänge des einfallenden Lichts in der Absorberschicht zu erhöhen. Neben bereits kommerziell eingesetzten Pyramidenoberflächen sind Dünnschicht-Solarzellen bekannt, bei denen die leitfähige transparente Schicht (Frontkontakt) als Nanosäulen oder Nanolöcher ausgebildet wird, um welche herum bzw. in welchen die aktive Siliziumschicht abgeschieden wird. Die Erzeugung dieser Nanostrukturen erfolgt im Labormaßstab durch Elektronenstrahllithographie.

Eine Aufskalierung dieses Prinzips für einen kommerziell lohnenden Flächendurchsatz ist aus Kosten- und Aufwandsgründen nicht möglich. Andererseits kann die leitfähige transparente Schicht bzw. der Frontkontakt direkt bei der Herstellung mittels thermischer chemischer Gasphasenabscheidung bzw. mittels Zerstäuben durch nachträgliches nasschemisches Ätzen in HCl texturiert werden. Bei dieser Vorgehensweise können jedoch keine ausreichenden Strukturtiefen erzeugt und somit keine wirkliche Verbesserung der Lichtausnutzung erzielt werden. Bislang ist somit aus dem Stand der Technik kein wirtschaftliches Verfahren bekannt, um großflächig und mit ausreichendem Durchsatz die geforderten Strukturen bzw. die geforderten Strukturtiefen in Dünnschicht-Solarzellen zu erreichen. Von Stock M. L. et al. sind in "Reliable Highrepetition Rate, Femtosecond, microJoule Fibre Laser for Precision Applications", PROCEEDINGS OF SPIE, Bd. 5714, (2005-01-27), Seiten 63-72 Möglichkeiten beschrieben, die eine robuste Konstruktion betreffen, die in bekannte Systeme integriert werden kann.

D. Hauschild et al. beschreiben in "Optimizing Laser Beam Profiling using Micro-lens Arrays for Efficient Material Processing: Application to Solar Cells"; PROCEEDING OF SPIE, Bd. 7202, (2009-01-28), Seiten 72020U1-U15, wie mit einem geeigneten Strahlprofil und einer geeigneten Intensitätsverteilung Verbesserungen erreicht werden können.

Die WO 2005/053037 A1 betrifft ein Verfahren zur Verwendung der Reflexion an Halbleiteroberflächen, unter Einsatz gebündelter Laserstrahlung.

Ausgehend von diesem Stand der Technik ist es daher die Aufgabe der vorliegenden Erfindung ein Herstellungsverfahren für ein elektrisches, photoelektrisches, elektrooptisches und/oder optisches Dünnschichtbauelement, insbesondere eine Dünnschichtsolarzelle oder organische Leuchtdiode, zur Verfügung zu stellen, mit dem eine notwendige Strukturierung einer optisch transparenten, elektrisch leitfähigen Schicht (die als einer der elektrischen Kontakte des Dünnschichtbauelements dient) zuverlässig, wiederholbar, mit ausreichend hohem Flächendurchsatz, wirtschaftlich und mit ausreichend großen Strukturtiefen von z.B. senkrecht zur Schichtebene verlaufenden Hohlstrukturen (nachfolgend: Vertiefungen) erfolgen kann. Aufgabe ist es darüber hinaus ein durch das erfindungsgemäße Herstellungsverfahren hergestelltes Dünnschichtbauelement, insbesondere eine organische Leuchtdiode, zur Verfügung zu stellen.

Die vorstehend beschriebene Aufgabe wird durch ein Herstellungsverfahren gemäß Anspruch 1 gelöst. Vorteilhafte Ausgestaltungsformen lassen sich jeweils den abhängigen Ansprüchen entnehmen.

Nachfolgend wird die Erfindung zunächst allgemein, dann anhand mehrerer Ausführungsbeispiele beschrieben. Die im Rahmen der Ausführungsbeispiele in Kombination gezeigten Einzelmerkmale müssen dabei nicht genau in der in den Beispielen gezeigten Konfiguration verwirklicht werden, sondern können im Rahmen der vorliegenden Erfindung auch in andersartigen Kombinationen realisiert werden. Insbesondere können einzelne der in den Ausführungsbeispielen beschriebenen Verfahrensschritte auch weggelassen werden.

Die Grundidee der vorliegenden Erfindung basiert darauf, die Beschichtung des Substrats des Dünnschichtbauelementes mit derjenigen Schicht (es können auch mehrere Schichten sein), durch die der dem Bauelement zugrunde liegende elektrische, photoelektrische, elektrooptische und/oder optische Effekt erzeugt wird (diese Schicht bzw. dieses Schichtsystem wird nachfolgend alternativ abgekürzt auch als "aktive" Schicht bezeichnet), mit einer Laserstrukturierung einer zwischen dem Substrat des Dünnschichtbauelementes und dieser aktiven Schicht angeordneten, optisch transparenten, elektrisch leitfähigen Schicht (die dann als einer der elektrischen Kontakte des Dünnschichtbauelementes dient) zu verknüpfen. Auf der diesem (ersten) elektrischen Kontakt gegenüberliegenden Seite der aktiven Schicht kann dann auf übliche Art und Weise ein weiterer elektrischer Kontakt (in der Regel: Rückseitenkontakt) des Dünnschichtbauelementes ausgebildet werden (z.B. ebenfalls über ein Abscheidungsverfahren). Bei dem zu strukturierenden optisch transparenten ersten elektrischen Kontakt handelt es sich somit in der Regel um den Frontseitenkontakt eines Dünnschichtbauelementes, der in der Regel auf einem ebenfalls transparenten Substrat (z.B. Glas oder Kunststoff) des Dünnschichtbauelementes ausgebildet wird.

Die vorbeschriebene Laserstrukturierung wird so durchgeführt, dass in der zu strukturierenden, später den ersten elektrischen Kontakt des Dünnschichtbauelements bildenden, optisch transparenten und elektrisch leitfähigen Schicht (die nachfolgend abgekürzt als TCF-Schicht bezeichnet wird, von englisch: transparent conductive film, auch wenn es sich dabei ggf. auch um ein Schichtsystem aus mehreren Einzelschichten handeln kann) ein lokal in der Schichtebene variierender Intensitätseintrag erfolgt, so dass durch diesen Intensitätseintrag in der Schichtebene an einer Vielzahl von Stellen ein Materialabtrag der TCF-Schicht erzeugt, also eine Vielzahl von Vertiefungen ausgebildet wird.

In die so ausgebildeten, sich senkrecht zur Schichtebene gesehen in die TCF-Schicht erstreckenden Vertiefungen wird dann ein zur Ausbildung des vorbeschriebenen Effektes geeignetes Material, also das Material der aktiven Schicht(en), eingebracht. Dies geschieht bevorzugt konformal, d.h. mit im Wesentlichen konstanter Schichtdicke der aktiven Schicht(en). (Grundsätzlich ist es auch denkbar, die einzelnen Vertiefungen mit diesem Material aufzufüllen; dies hat jedoch in der Regel den Nachteil, dass die Wahrscheinlichkeit für Defekte in der/den aktiven Schicht(en) in den aufgefüllten Bereichen höher ist und dass eine entsprechende Abscheidung länger dauert.) Das Einbringen des aktiven Materials kann insbesondere durch bevorzugt konformale Materialabscheidung erfolgen. Bevorzugt handelt es sich bei diesem Material um amorphes Silizium (nachfolgend auch als a-Si abgekürzt) und/oder auch um mikrokristallines Silizium (nachfolgend auch als *µ*-Si abgekürzt) und bei dem so hergestellten Dünnschichtbauelement um eine Dünnschichtsolarzelle. Das aktive Material kann in verschiedenen Schichten übereinander gestapelt in die Vertiefungen eingebracht werden. Sind die Vertiefungen mit aktivem Material beschichtet, so kann weiteres Material, z.B. der Rückkontakt, vollflächig aufgetragen oder abgeschieden werden.

Im Rahmen der Erfindung ist es selbstverständlich auch möglich, anstelle einer einzelnen, zu strukturierenden TCF-Schicht ein aus entsprechenden Materialien aufgebautes mehrschichtiges TCF-Schichtsystem abzuscheiden, bei dem dann eine oder mehrere der abgeschiedenen einzelnen TCF-Schichten durch Lasereinstrahlung tiefenstrukturiert wird/werden.

Das Laserlicht kann unmittelbar in das Innere der mindestens einen zu strukturierenden TCF-Schicht eingestrahlt werden (beispielsweise: fokussiert werden), es ist jedoch grundsätzlich auch denkbar dieses z.B. randseitig auf die TCF-Schicht so einzustrahlen, dass ein Energieübertrag in diese Schicht und somit ein Materialabtrag aus dieser Schicht erfolgt. Die Laserlichteinstrahlung erfolgt dabei in der Regel wie nachfolgend noch im Detail beschrieben so, dass ein örtlich variierender Lichtintensitätseintrag (in der Schichtebene gesehen) erfolgt, so dass ein strukturierter, in der Schichtebene gesehen örtlich variierender Materialabtrag aus dieser Schicht (z.B. Verdampfen oder Aufschmelzen) zur Ausbildung der einzelnen Vertiefungen erfolgt.

Bei dem erfindungsgemäßen Verfahren erfolgt die Laserlichtstrukturierung derart, dass mehrere kohärente Laserstrahlen in einem Überlagerungsbereich (nachfolgend auch: Überlappungsbereich) unter vordefiniertem Winkel (bei zwei Strahlen) oder vordefinierten Winkeln (bei mehr als zwei Strahlen) zur Interferenz gebracht werden. Die zu strukturierende(n) TCF-Schicht(en) wird/werden dann an (einer) vordefinierten Position(en) in diesem Überlagerungsbereich positioniert. Die mehreren Laserstrahlen können mittels eines Strahlteilers aus einem einzelnen, von einem Laser emittierten Laserstrahl erzeugt und unter Verwendung von Strahlumlenkern in den Überlagerungsbereich geführt werden.

Bevorzugt wird die TCF-Schicht mit einer Vielzahl von Vertiefungen in Form einer in der Schichtebene periodischen Vertiefungsstruktur strukturiert. Hierbei kann es sich um eine in der Schichtebene gesehen in einer Richtung (also eindimensional) periodisch ausgebildete Vertiefungsstruktur handeln. Ebenso ist jedoch auch eine zweidimensional periodische Vertiefungsstruktur mit einer Periodizität in zwei zueinander unter einem Winkel von ≠ 0°, bevorzugt von 90° (senkrechte Gittergrabenstruktur) stehenden Richtungen realisierbar.

Auf diese Art und Weise kann (was nachfolgend noch im Detail beschrieben wird) eine Laserstrukturierung der TCF-Schicht(en) wie folgt erfolgen:
- Linienartige Muster mit periodischen Abständen,
- kreuzartige Muster erreicht durch Mehrfachbestrahlung mit Linienmustern unter spezifischen Rotationswinkeln (z.B. Drehen des Substrats nach einer Bestrahlung mit einen linienartiges Interferenzmuster um 30°, 60° oder 90°),
- kombinierte kreuzartige Muster mit unterschiedlichen Linienabständen,
- verschiedene Anordnungen von Vertiefungen (Löchern) mit unterschiedlichen Abständen oder auch mit gleichen Abständen oder
- auch beliebige Kombinationen der voranstehend aufgeführten Strukturierungen.

Weitere besonders vorteilhafte Formen von Vertiefungsstrukturen lassen sich den abhängigen Patentansprüchen sowie den nachfolgend noch im Detail beschriebenen Ausführungsbeispielen entnehmen. Ebenso sind für die Tiefe und für die laterale Ausdehnung der einzelnen einzubringenden Vertiefungen einer periodischen Vertiefungsstruktur vorteilhafte Größenordnungen in den abhängigen Ansprüchen aufgeführt. Entsprechendes gilt für vorteilhafte Abstände der einzelnen Vertiefungen einer periodischen Vertiefungsstruktur oder für vorteilhafte Aspektverhältnisse (Verhältnis von Tiefe zu lateraler Ausdehnung der einzelnen Vertiefungen). Auch lassen sich vorteilhafte Schichtdicken für die zu strukturierend(n) TCF-Schicht(en) den abhängigen Ansprüchen entnehmen.

Erfindungsgemäß lässt sich die Oberfläche der TCF-Schicht(en) beispielsweise in einer Größenordnung von 200 nm bis 500 µm Tiefenausdehnung der eingebrachten Vertiefungen strukturieren, auf und/oder in dieser strukturierten Schicht und/oder in den durch die Strukturierung geschaffenen Hohlräumen derselben lässt sich dann z.B. die amorphe Siliziumschicht dreidimensional abscheiden, bevor eine Rückkontaktschicht als weiterer elektrischer Kontakt aufgebracht werden kann.

Die Laserstrukturierung der TCF-Schicht(en) wird nachfolgend noch ausführlich beschrieben, die zuvor und danach erfolgenden Einzelschritte zur Herstellung des Dünnschichtbauelements (also z.B. die Beschichtung des Dünnschichtbauelementes mit der/den TCF-Schicht(en), mit dem aktiven Material und das Aufbringen eines Rückkontakts) können dabei mit Verfahren (z.B. PVD-Verfahren oder auch mit CVD-Verfahren) durchgeführt werden, die dem Fachmann auch hinsichtlich der einzustellenden Abscheidungsparameter grundsätzlich bekannt sind und sich aus den verwendeten Materialien ergeben.

Mit dem erfindungsgemäßen Verfahren ist es möglich, großflächig und mit Durchlaufgeschwindigkeiten von 1 bis 100 cm²/s die für die "dreidimensionalen" Dünnschichtsolarzellen gewünschten Strukturen in einer optisch transparenten, elektrisch leitfähigen Schicht (TCF-Schicht) zu erzeugen. Dabei sind die Strukturgrößen anpassbar für amorphe Siliziumsolarzellen und auch für Tandemzellen aus amorphen Silizium und mikrokristallinem Silizium, bei denen z.B. in den eingebrachten Vertiefungen schichtweise beide Siliziumarten übereinander gestapelt werden.

Die vorliegende Erfindung lässt sich jedoch nicht nur zur Herstellung von Dünnschicht-Solarzellen verwenden, sondern auch zur Herstellung von lichtemittierenden Elementen.

Erfindungsgemäß kann es sich bei dem Dünnschichtbauelement insbesondere um eine Kupfer-Indium-Diselenid (kurz: CIS)-Dünnschichtsolarzelle oder eine so genannte CIGS-Solarzelle, bei der zusätzlich Gallium zugegeben wird, handeln. Ebenso kann erfindungsgemäß eine Dünnschichtsolarzelle auf Basis organischer Halbleiter, auf Basis von amorphem und/oder mikrokristallinem Silizium (ggf. wasserstoffdotiert) oder eine Dünnschichtsolarzelle auf Basis von Galiumarsenid oder Cadmium-Tellurit hergestellt werden.

Das TCF-Material kann insbesondere ein transparentes, leitfähiges Oxid (TCO = transparent conductive oxide), hier bevorzugt dotiertes Zinnoxid oder Zinkoxid sein. Auch transparente und/oder leitfähige Polymere, hier bevorzugt PEDOT und/oder PEDOT:PSS können als TCF-Schichtmaterial verwendet werden. Wie die einzelnen Materialien vor ihrer Strukturierung auf dem Substrat abzuscheiden sind, ist dem Fachmann dabei bekannt. Auch können Kohlenstoff-Nanoröhren-Netzwerke als TCF-Schichtmaterialien eingesetzt werden.

Bei dem durch die aktive Schicht erzeugten Effekt kann es sich insbesondere um eine Absorption elektromagnetischer Strahlung, insbesondere im Bereich des sichtbaren Lichts, und um eine Umwandlung dieser Strahlung in elektrische Ladungsträger (Elektron-Loch-Paare gemäß der Solarzellenfunktion) handeln. Ebenso ist es möglich, die aktive Schicht so auszugestalten, dass die Energie elektrischer Ladungsträger (zugeführt über die TCF-Schicht als erstem elektrischen Kontakt und einem weiteren, auf der Rückseite der aktiven Schicht(en) angeordneten elektrischen Kontakt) bevorzugt durch Rekombination dieser Ladungsträger in elektromagnetische Strahlung, insbesondere im Bereich des sichtbaren Lichts, umgewandelt wird (Funktionsweise bei den organischen Leuchtdioden). Vorteilhafterweise für diese Funktion eingesetzte Materialien lassen sich ebenfalls den abhängigen Patentansprüchen entnehmen.

In weiteren vorteilhaften Ausgestaltungsformen ist/sind die zu strukturierenden TCF-Schichtmaterialien im sichtbaren Wellenlängenbereich, im IR-Bereich und/oder im UV-Wellenlängenbereich optisch transparent (Absorptionsgrad bevorzugt kleiner 10%). Dies gilt bevorzugt ebenso für das verwendete Substrat, so dass hier vorteilhafterweise Glas und/oder transparente Kunststofffolien eingesetzt werden können. Das Substrat kann flexibel oder auch starr sein.

Die zur Strukturierung der TCF-Schicht(en) verwendete Laserstrahlung kann gepulst oder kontinuierlich und/oder mit mindestens einer Laserwellenlänge im sichtbaren, im infraroten und/oder im ultravioletten Bereich zugeführt werden. Besonders bevorzugt werden Nd:YAG Laser verwendet mit Wellenlängen im UV-, im IR- oder im visuellen Bereich (266 nm, 355 nm, 532 nm oder 1064 nm).

Nachfolgend wird das erfindungsgemäße Herstellungsverfahren und das durch dieses ausgebildete, erfindungsgemäße Dünnschichtbauelement anhand mehrerer Ausführungsbeispiele beschrieben.

Es zeigen:
- Figur 1: eine Skizze für eine Dünnschichtsolarzelle die erfindungsgemäß herstellbar ist.
- Figur 2: verschiedene Vertiefungsstrukturformen der vorliegenden Erfindung.
- Figur 3: eine nicht zur Erfindung gehörende Mikrolinsen-Array-Konfiguration zur Ausführung eines erfindungsgemäßen Herstellungsverfahrens.
- Figur 4: verschiedene Mikrolinsen-Arrays für den Aufbau gemäß Figur 3.
- Figur 5: einen direkten Laser-InterferenzStrukturierungsaufbau für ein Herstellungsverfahren gemäß der vorliegenden Erfindung in Zwei-Strahl-Konfiguration.
- Figur 6: einen entsprechenden Aufbau wie in Figur 5 in Drei-Strahl-Konfiguration.
- Figur 7: einen entsprechenden Aufbau wie in Figur 5 in Vier-Strahl-Konfiguration.
- Figur 8: eine Prinzipskizze zur erfindungsgemäßen Erzeugung einer Vertiefungsstruktur in einer Substratbasis durch ein Herstellungsverfahren gemäß Figuren 5 bis 7.
- Figuren: in Zwei-, Drei- oder Vier-Strahl-
- 9 bis 11: Konfiguration erzeugte Intensitätsmuster.
- Figur 12: ein prinzipieller Schichtaufbau einer siliziumbasierten Dünnschichtsolarzelle, die gemäß einem erfindungsgemäßen Herstellungsverfahren herstellbar ist.
- Figuren 13: Strukturierungsbeispiele für
- und 14: erfindungsgemäß strukturierte TCF-Schichten.

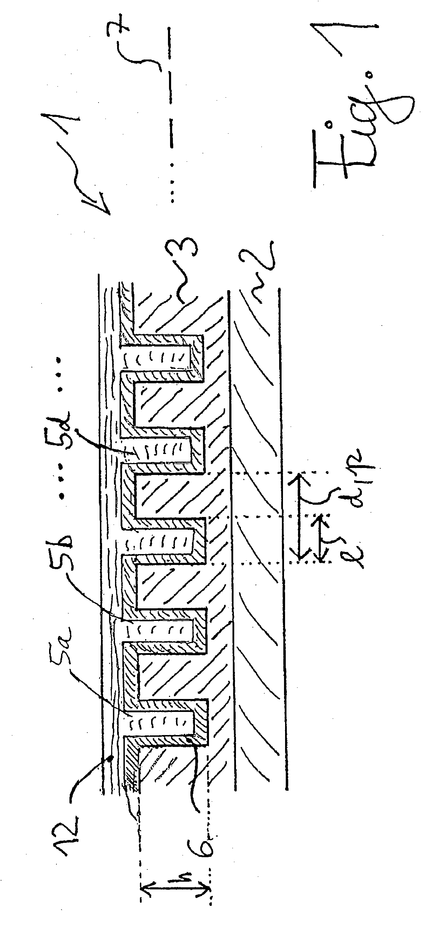

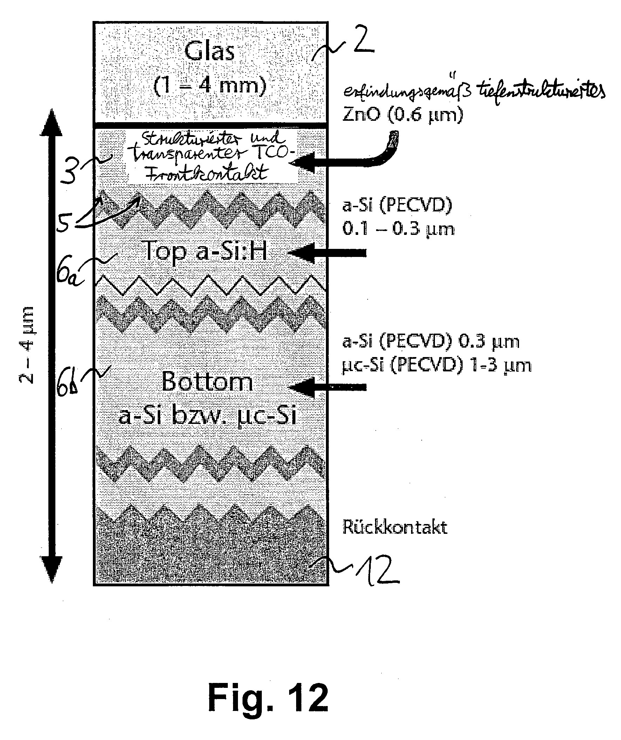

Figur 1 zeigt in einem Querschnitt senkrecht zur Schichtebene 7 eines erfindungsgemäßen Dünnschichtbauelements den Aufbau einer erfindungsgemäß herstellbaren Dünnschichtsolarzelle 1. Auf einem 1 mm dicken, transparenten Glassubstrat 2 wird mit Hilfe eines plasmaunterstützten chemischen Gasphasenabscheidungsverfahrens PECVD (das mit Bezug auf Figur 12 noch näher beschrieben wird) eine insgesamt 0,6 µm dicke, einzelne TCF-Schicht aus z.B. dotiertem Zinkoxid 3 abgeschieden.

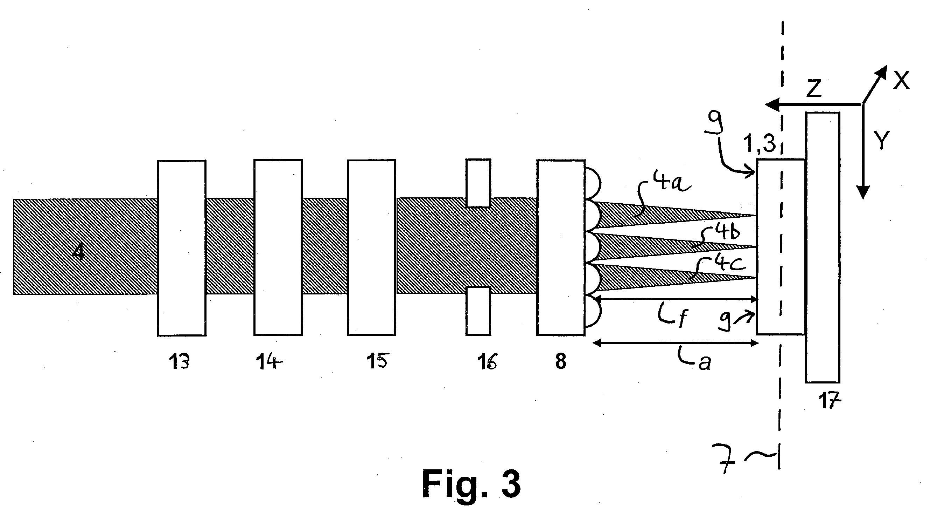

Wie mit Bezug auf die Figuren 3 bis 11 nachfolgend noch ausführlich beschrieben wird, erfolgt dann eine Laserstrukturierung der abgeschiedenen TCF-Schicht 3, bei der ein (in der Schichtebene 7 der Dünnschichtsolarzelle 1 bzw. der TCF-Schicht 3 gesehen) lokal variierender Intensitätseintrag in die TCF-Schicht dadurch realisiert wird, dass die TCF-Schicht 3 mit einer Vielzahl einzelner Laser(teil)strahlen bestrahlt wird. Die Laserintensität wird dabei so eingeregelt, dass lokal am Ort des Auftreffens der einzelnen Laserstrahlen ein Materialabtrag in der TCF-Schicht 3 erfolgt.

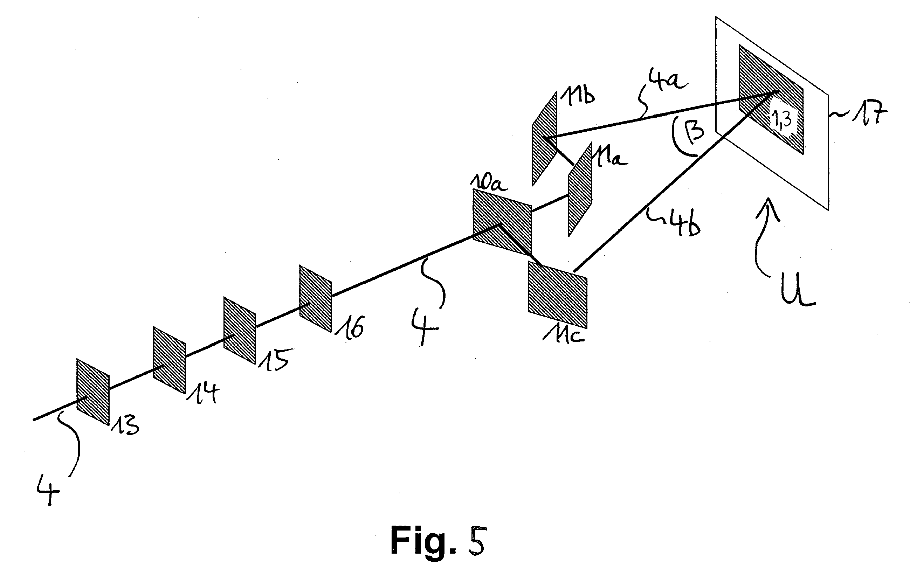

Die Intensität der Laserstrahlen wird hierbei durch Überlagerung von mehreren Strahlen (Fig. 5 bis 11) so eingeregelt, dass die durch den Materialabtrag im Interferenzmaximum realisierten, einzelnen Vertiefungen 5a, 5b, ... eine Tiefe h senkrecht zur Schichtebene 7 von ca. 0,4 µm erhalten, dass also senkrecht zur Schichtebene gesehen ca. zwei Drittel der TCF-Schicht lokal abgetragen (z.B. verdampft oder aufgeschmolzen) wird.

Durch Kontrolle der Auftreffwinkel von z.B. zwei Laserstrahlen (Fig. 5) kann die Periodizität p der Interferenzmuster variiert werden (in der Schichtebene 7 gesehen). Auf diese Art und Weise entsteht eine Vielzahl einzelner, geradliniger, parallel zueinander und in konstanten Abständen d voneinander verlaufender Gräben als Vertiefungen 5a, 5b, ... in der substratabgewandten Oberfläche der TCF-Schicht 3. Der Abstand d benachbarter Gräben (also die Periodizität p der erzeugten eindimensionalen Vertiefungsstruktur 5) beträgt hier ca. 1,5 µm. Die erzeugte Grabenbreite in der Schichtebene 7 und senkrecht zu den Grabenlängsachsen beträgt ca. 1 = 0,75 µm. Es ergibt sich somit ein Aspektverhältnis A = h/l = 0,4/0,75. Anstelle der Gräben können jedoch bei Dünnschichtsolarzellen insbesondere auch Säulen oder Löcher bzw. Lochmuster als Vertiefungen einstrukturiert werden.

Nach der Laserstrukturierung der TCF-Schicht 3 wird das Element 2,3 einem weiteren plasmaunterstützten chemischen Gasphasenabscheidungsprozess bzw. PECVD-Prozess zur Abscheidung des aktiven Materials 6 in den erzeugten Vertiefungen 5a, 5b unterzogen. Im vorliegenden Fall wird eine Schicht 6 aus amorphem Silizium a-Si:H (wasserstoffdotiert) in den Vertiefungen 5a, 5b, ... konformal abgeschieden. Die Schichtdicke beträgt hier ca. 0.3 µm.

Der zweite Kontakt (Rückseitenkontakt 12) wird auf der substratabgewandten Seite der Schicht 6 mittels eines dem Fachmann bekannten CVD-Prozesses abgeschieden. Der Rückseitenkontakt 12 besteht hier ebenfalls aus transparentem, leitfähigem Oxid, z.B. dotiertem Zinkoxid. Der Rückseitenkontakt ist hier ca. 2 µm dick.

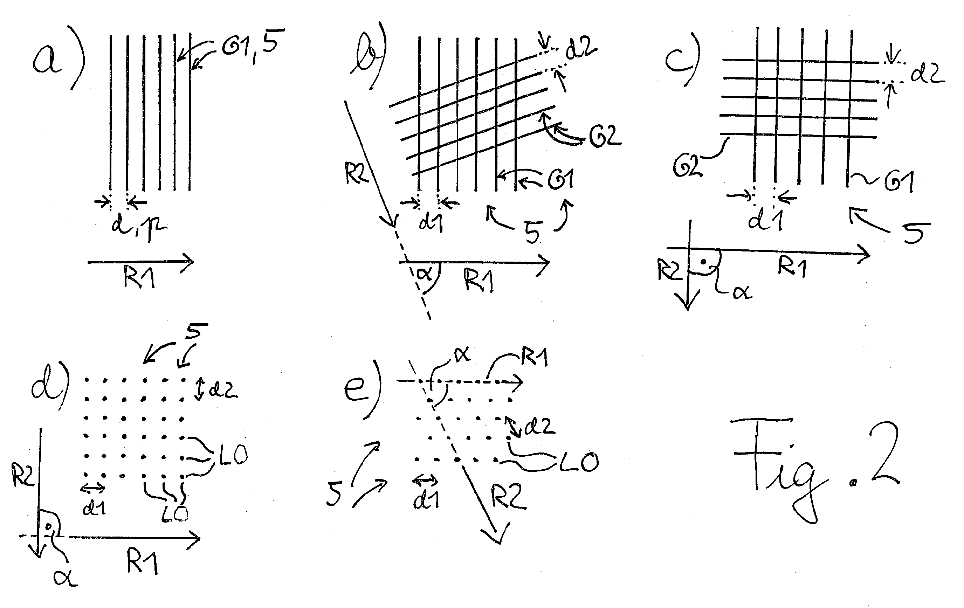

Fig. 2 zeigt verschiedene periodische Vertiefungsstrukturen 3, die durch Laserstrukturierung und parallel zur Schichtebene 7 verlaufend in der TCF-Schicht 3 ausgebildet werden können. So zeigt Fig. 2a) eine eindimensionale Vertiefungsstruktur 5 in Form einer Grabenstruktur G1, bei der eine Vielzahl von parallelen Gräben beabstandet voneinander verläuft. Der Abstand d unmittelbar benachbarter Gräben bzw. die Periodizität p in Richtung R1 senkrecht zu den Grabenlängsachsen kann beispielsweise zwischen 0,2 µm und 100 µm betragen.

Fig. 2b) zeigt eine Überlagerung zweier solcher Grabenstrukturen unter einem Winkel α ≠ 0° (hier: α = 70°): Beispielsweise kann zunächst mithilfe eines Zylinderlinsen-Mikrolinsen-Arrays die erste Grabenstruktur G1 (Grabenabstand d1) in Richtung R1 erzeugt werden, bevor die TCF-Schicht um α gedreht wird, um anschließend durch erneute Laserbestrahlung durch das Zylinderlinsen-Mikrolinsen-Array (oder mit einem linienartigen Interferenzmuster) die zweite Grabenstruktur G2 (Grabenabstand d2) in Richtung R2 (die dann um α in Bezug auf die Richtung R1 gedreht ist) zu erzeugen.

Fig. 2c) zeigt den Fall aus Fig. 2b), bei dem α = 90° ist, also zwei senkrecht zueinander ausgerichtete und in der TCF-Schicht 3 ausgebildete Grabenstrukturen G1, G2 (Kreuzgitter).

Fig. 2d) zeigt ein Beispiel, bei dem die Vertiefungsstruktur 5 nicht in Form von einer oder mehrerer Grabenstruktur(en) ausgebildet ist, sondern eine Vielzahl von einzelnen Löchern LO umfasst. Die Löcher LO sind an den Kreuzungspunkten eines quadratischen Gitters angeordnet, sodass sich hier eine zweidimensionale Periodizität der Vertiefungsstruktur in zwei zueinander senkrechten Richtungen R1 und R2 ergibt (der Lochabstand bzw. die Lochperiode d1 in Richtung R1 und der Lochabstand bzw. die Lochperiode d2 in Richtung R2 sind hier identisch). Beispielsweise ist d1 = d2 = 1,5 µm und es werden ein Lochdurchmesser 1 in der Schichtebene von 0,75 µm und eine Lochtiefe h senkrecht zur Schichtebene von 0,4 µm gewählt.

Fig. 2e) zeigt einen weiteren Fall einer periodischen Lochstruktur wie in Fig. 2d), wobei hier jedoch die beiden Richtungen R1 und R2, in denen die einzelnen Löcher LO jeweils in periodischen Abständen in Reihen angeordnet sind, nicht senkrecht aufeinander stehen, sondern einen Winkel von α = 70° ausbilden.

Fig. 3 zeigt einen ersten Aufbau zur Herstellung eines Dünnschichtbauelements 1 nach dem Stand der Technik. Der Aufbau umfasst einen Laser (nicht gezeigt), beispielsweise einen UV-emittierenden Laser mit einer Wellenlänge von *λ* = 266 nm. Der Laserstrahl 4 dieses Lasers wird hier in gepulster Form (es kann jedoch auch ein kontinuierlicher Laserstrahl erzeugt werden, das Element 13 entfällt dann) zunächst durch eine Vorrichtung 13 zur Kontrolle der Pulsanzahl, hier einen mechanischen Shutter, gestrahlt. Hinter dem mechanischen Shutter 13 ist im Strahlengang des Laserstrahls 4 ein Homogenisator 14 angeordnet. Der Homogenisator besteht aus einem System optischer Elemente, die z.B. ein top-hat Strahlprofil generieren. Im Strahlengang 4 hinter dem Homogenisator 14 ist ein Teleskopsystem 15 zur Kontrolle des bzw. zum Einregeln eines gewünschten Strahldurchmessers angeordnet. Diesem folgt im Strahlengang 4 eine Blende (hier: Irisblende) oder auch eine Rechteckblende 16, bevor der Laserstrahl 4 schließlich auf ein Mikrolinsen-Array 8 trifft. Die Blende 16 wird dazu verwendet, den Strahlumriss und den Strahldurchmesser des Laserstrahls 4 auf eine vorbestimmte Form (z.B. rechteckig) und Größe zu bringen. Die Reihenfolge der Komponenten 13 bis 16 kann hierbei auch anders als in Fig. 3 gezeigt gewählt werden. Gegebenenfalls kann auf die Elemente 13 bis 16 verzichtet werden.

Das Mikrolinsen-Array 8 ist hier ein Zylinderlinsen-Mikrolinsen-Array mit einer Vielzahl von in einer Ebene parallel zueinander und in konstanten Abständen voneinander angeordneten Zylinderlinsen (deren Längsachsen hier senkrecht zur dargestellten Ebene angeordnet sind). Die einzelnen Zylinderlinsen des Mikrolinsen-Arrays 8 haben einen Fokusabstand f. Durch das Mikrolinsen-Array 8 wird der Laserstrahl 4 somit in eine Vielzahl einzelner Teilstrahlen 4a, 4b, 4c, ... aufgeteilt, die in einem Abstand f hinter dem Mikrolinsen-Array 8 auf eine ebene Fläche 9 fokussiert werden.

Mithilfe eines in den drei Translationsrichtungen x, y und z eines Kartesischen Koordinatensystems bewegbaren Verschiebetisches 17 ist nun das Substrat 1 mit dem Schichtsystem 2 (letzteres ist hier nicht gezeigt) so ausgerichtet, dass die zu strukturierende TCF-Schicht 3 (vgl. Fig. 1) parallel zur Fokusfläche 9 ausgerichtet ist. Im gezeigten Fall fallen die TCF-Schicht 3 und die Fokusfläche 9 zusammen, sodass die Teilstrahlen 4a, 4b, ... auf diese Oberfläche fokussiert werden (Fokusabstand f gleich Abstand a des Arrays 8 von der Oberfläche der TCF-Schicht 3). Durch geeignete Wahl der Strahlparameter des Laserstrahls 4 werden somit am Auftreffort der Teilstrahlen 4a, 4b, ... im Element 3 vorbeschriebene Vertiefungsstrukturen 5 erzeugt.

Zur Einstellung der Strukturgröße der Vertiefungsstruktur 5 kann der Abstand a zwischen Mikrolinsen-Array 8 und Substratbasis 1 verändert werden: Durch Verfahren der Substratbasis 1 mittels des Verschiebetisches 17 in +z-Richtung wird die Fokusebene 9 hinter die Oberfläche der Schicht 3 ins Innere der Schicht 3 verschoben; es werden dann Vertiefungen 5a, 5b, ... mit vergrößerter lateraler Ausdehnung 1 erzeugt. Entsprechendes geschieht bei einem Verfahren in -z-Richtung, da die Fokusebene 9 dann außerhalb der Schicht 3 und vor dieser liegt. Zur Regelung der Strukturgröße der Vertiefungsstruktur kann somit der Abstand a größer oder kleiner als der Fokusabstand f gewählt werden. Zusätzlich ist es möglich, durch Translation des Substrats 1 in x- und/oder y-Richtung mittels des Verschiebetisches 17 unterschiedliche Vertiefungsstrukturgeometrien mit kontrollierter Größe zu erzeugen.

Anstelle eines Verschiebetisches (mit oder ohne Rotationsachse) kann auch ein Roboter verwendet werden. Hierbei können sowohl die Komponenten 8 und 13 bis 16 als auch die Substratbasis 1 mit dem Verschiebetisch und/oder Roboter gekoppelt werden. Bei einem Anordnen der Komponenten 8 und 13 bis 16 an einem entsprechenden Verschiebetisch oder Roboter ist es vorteilhaft, fasergekoppelte Laser zu verwenden.

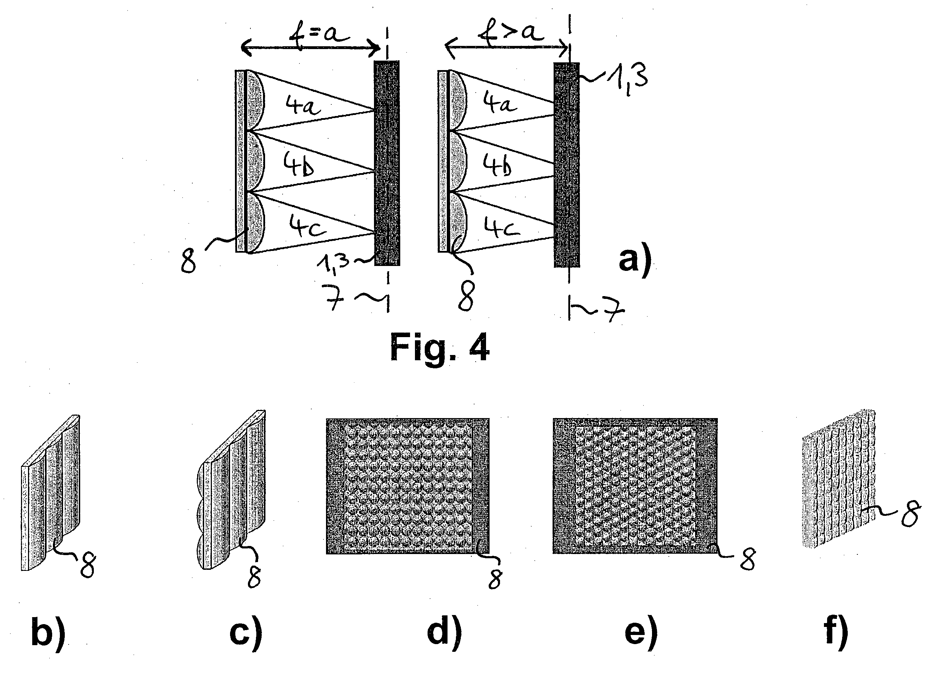

Fig. 4a) skizziert noch einmal, wie über eine Veränderung des Abstandes a relativ zum Fokusabstand f (Variation des Abstandes der TCF - Schicht 3 relativ zum Mikrolinsen-Array) die Strukturgröße, die der Schicht 3 einstrukturiert wird, geändert werden kann. Fig. 4b) bis f) zeigt, dass unterschiedliche Mikrolinsen-Arrays verwendet werden können: Linienerzeugende Mikrolinsen-Arrays mit zylindrischen (Fig. 4b)) Mikrolinsen, punkterzeugende Mikrolinsen mit gekreuzten zylindrischen (Fig. 4c)) Mikrolinsen, mit hexagonalen (Fig. 4d)) oder quadratischen (Fig.4e)) Linsenanordnungen und quadratische Mikrolinsen-Arrays (Fig. 4f)). Alle dies Mikrolinsen-Arrays 8 aus den Fig. 4b) bis 4f) können somit im in Fig. 3 gezeigten Aufbau verwendet werden.

Beim in den Fig. 3 und 4 gezeigten Aufbau lassen sich unterschiedliche Laserwellenlängen verwenden. Für gepulste Laser (mit Pulslängen z.B. im Nanosekunden-, Pikosekunden- oder Femtosekunden-Bereich) können verschiedene Prozesse wie Abtrag, Aufschmelzen, Phasenumwandlung, lokales Härten usw. bei der Ausbildung der Vertiefungsstruktur 5 in der Schicht 3 erreicht werden. Ebenso sind direkte Oberflächenmodifikationen mit einem Laserpuls möglich. Die Anzahl der Laserpulse kann variiert werden, um die Form und Tiefe der Oberflächenmodifikationen 5 zu kontrollieren. Auch kann die Laserintensität variiert werden, um unterschiedliche Geometrien der Modifikationen 5 zu erhalten.

Fig. 5 zeigt einen Aufbau für eine direkte LaserInterferenz-Strukturierung für die Herstellung eines beispielhaften, zur Erfindung nicht gehörenden Dünnschichtbauelements. Ein gepulster Laserstrahl 4 mit vordefinierter Intensität wird zunächst durch eine Vorrichtung 13 zur Kontrolle der Pulsanzahl (hier: mechanischer Shutter) gestrahlt (alternativ dazu kann auch ein kontinuierlicher Laserstrahl verwendet werden, in diesem Falle kann die Vorrichtung 13 gegebenenfalls entfallen). Im Strahlengang nach der Vorrichtung 13 ist ein Homogenisator (hier: eine zylindrische oder rechteckige Blende) 14 angeordnet. Der den Homogenisator verlassende Laserstrahl wird über ein Teleskopsystem 15, mit dem der Strahldurchmesser auf eine vordefinierte, gewünschte Größe (z.B. 5 mm) gebracht wird, gestrahlt. Dem Teleskopsystem 15 folgt eine Blende (z.B. Irisblende) oder eine Rechteckblende 16, um auf eine vordefinierte, gewünschte Form (z.B. rechteckig) und Strahlgröße zu kommen, und ein vordefiniertes Strahlprofil einzustellen.

Im Strahlengang nach der Blende 16 folgt ein erster, hier auch einziger Strahlteiler 10a, mit dem der Laserstrahl 4 in zwei Teilstrahlen 4a und 4b aufgetrennt wird. Der erste Teilstrahl 4a wird über zwei in dessen Strahlengang angeordnete Strahlumlenker in Form von Spiegeln 11a und 11b umgelenkt und schließlich unter einem vordefinierten Winkel auf die TCF-Schicht 3 (hier nicht gezeigt) eingestrahlt. Die Substratbasis 1 ist hier, ähnlich wie in Fig. 3 gezeigt, auf einem Verschiebetisch 17 angeordnet. Der den Strahlteiler 10a verlassende zweite Teilstrahl 4b wird über einen weiteren Spiegel 11c umgelenkt und ebenfalls unter einem definierten Winkel auf die TCF-Schicht 3 eingestrahlt. Die beiden vorgenannten Einstrahlungswinkel der beiden Teilstrahlen 4a und 4b sind so ausgebildet, dass die beiden Teilstrahlen unter einem Winkel β von z.B. 40° aufeinander zulaufen und sich in einem Überlagerungsbereich U kreuzen bzw. überlagern. In diesem Überlagerungsbereich U, in dem sich die beiden Teilstrahlen 4a, 4b kreuzen, also überlagern, ist die Schicht 3 angeordnet, in deren Oberfläche die Vertiefungsstruktur 5 einzubringen ist. Der Winkel β zwischen den beiden Laserstrahlen 4a, 4b kann variiert werden, um Strukturen unterschiedlicher Periodizität zu erzeugen.

Mithilfe des Verschiebetisches 17 kann ein Verschieben der Elemente 1, 3 erfolgen, so dass große, ebene wie nicht ebene (z.B. zylinderförmige) Oberflächen tiefenstrukturiert 5 werden können. Die Verschiebung kann sowohl orthogonal zur Strahlachse 4 (z.B. lateral oder vertikal), parallel zur Strahlachse 4 und/oder aus einer Rotation der Elemente 1, 3 bestehen. Die laterale Ausdehnung 1 und/oder die Tiefe h der Strukturen 5 können über die Strahlintensität, Bestrahlungsdauer und/oder Pulsanzahl eingestellt werden.

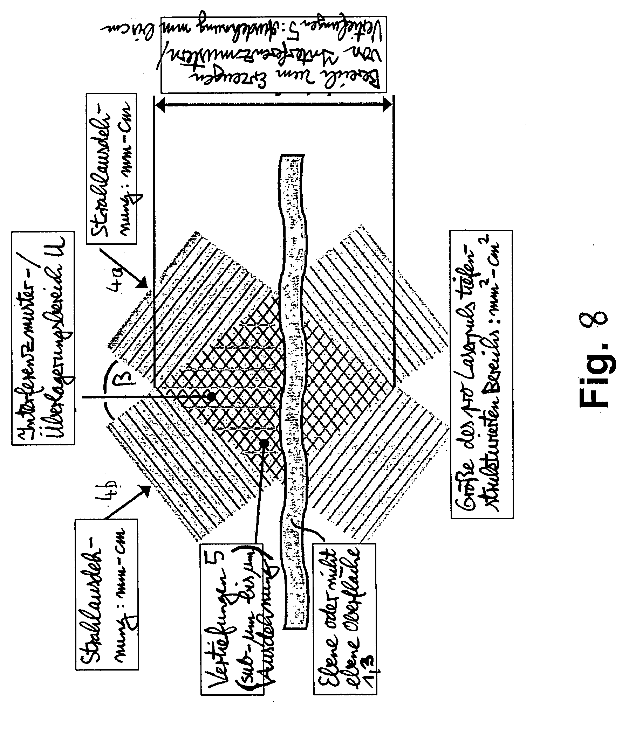

Fig. 8 skizziert den Überlagerungsbereich U aus Fig. 5 im Detail: Beide sich unter dem Winkel β überlagernde Strahlen 4a, 4b bilden im Überlagerungsbereich U, in dem die Oberfläche der Schicht 3 bzw. die Schicht 3 angeordnet ist, ein Interferenz-Muster (stehende Wellenstruktur) aus, an deren Maxima eine periodische Tiefenstrukturierung 5 der Schicht 3 erfolgt (an den zwischen den Maxima liegenden Knoten der Interferenz-Struktur erfolgt keine Tiefenstrukturierung der Schicht 3, da hier die einfallende Intensität niedriger ist (evtl. auch Null)).

Die in den Fig. 5 und 8 gezeigte direkte Laserstrahlinterferenzstrukturierungsmethode ermöglicht somit die Herstellung periodischer zweidimensionaler oder dreidimensionaler Mikrostrukturierungen auf allen Arten von Schichten 3 und Bauteilgeometrien. Um eine Interferenzstruktur zu erzeugen, werden N (mit N ≥ 2) kollimierte und kohärente Laserstrahlen 4a, 4b, ... auf oder unter einer Oberfläche 3 überlagert. Hiermit ergibt sich insbesondere auch der Vorteil, dass sowohl ebene, als auch nicht ebene, gekrümmte Oberflächen strukturiert werden können, da die Interferenz in dem gesamten überlappenden Volumen der einzelnen Teilstrahlen 4a, 4b, ... stattfindet.

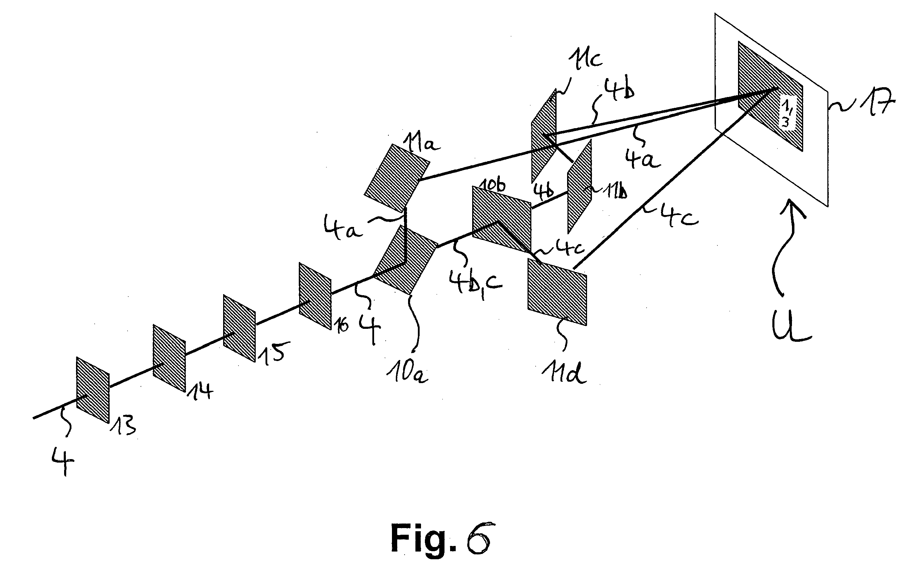

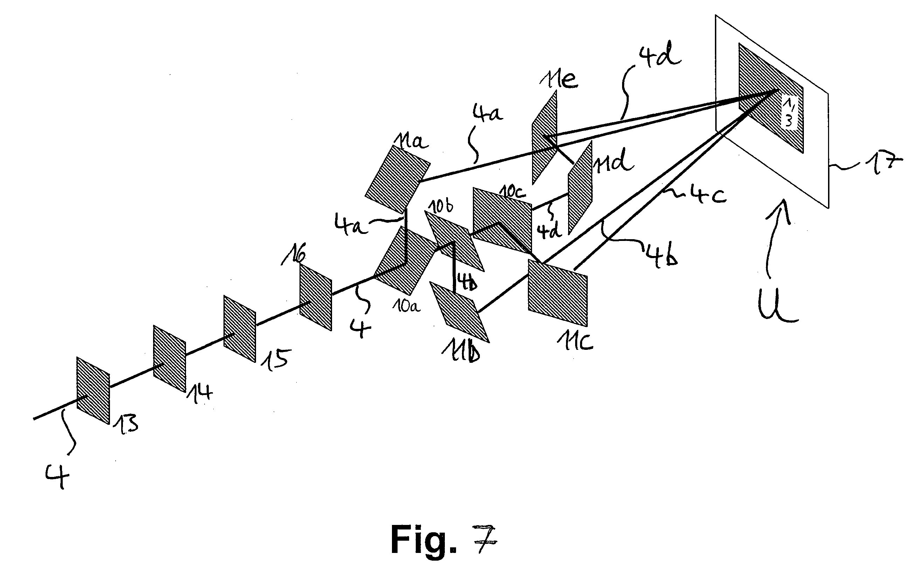

Fig. 6 und 7 zeigen zwei weitere Aufbauten für direkte Laserinterferenz-Strukturierungen. Diese sind grundsätzlich wie der in Fig. 5 gezeigte Aufbau ausgebildet, sodass nachfolgend nur die Unterschiede beschrieben werden: Beim in Fig. 6 gezeigten Aufbau handelt es sich um einen Drei-Strahl-Aufbau, bei dem über zwei hintereinander in den Strahlengang des Laserstrahls 4 eingebrachte Strahlteiler 10a, 10b eine Aufspaltung in drei einzelne Teilstrahlen 4a, 4b und 4c erfolgt, die dann mithilfe entsprechender Spiegel 11a bis 11d aus drei unterschiedlichen Richtungen, also unter unterschiedlichen Winkeln auf die Schicht 3 eingestrahlt werden. Die drei Teilstrahlen 4a bis 4c überlappen sich somit ebenfalls in einem Überlagerungsbereich U, in dem das Substrat 1 angeordnet ist.

Fig. 7 zeigt eine entsprechende Vier-Strahl-Anordnung, bei der über drei hintereinander im Strahlengang der Laserstrahlung 4 angeordnete Strahlteiler 10a bis 10c eine Aufsplittung des Strahls 4 in insgesamt vier unterschiedliche Teilstrahlen 4a bis 4d erfolgt, die wiederum mittels unterschiedlich angeordneter und ausgerichteter Strahlumlenker 11a bis 11e aus vier unterschiedlichen Richtungen auf die im Überlagerungsbereich U angeordnete Schicht 3 eingestrahlt werden. Auch hier kreuzen bzw. überlappen sich alle vier Einzelstrahlen 4a bis 4d im Überlagerungsbereich U.

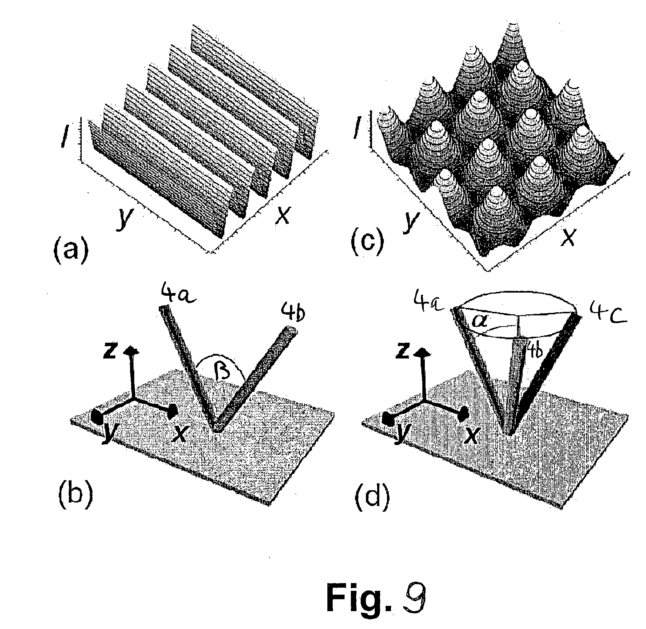

Fig. 9 zeigt ein Beispiel für eine durch (b) zwei einzelne Teilstrahlen 4a, 4b erzeugte (a) linienartige Interferenzstruktur sowie ein weiteres Beispiel für eine durch Überlagerung bzw. Interferenz von insgesamt drei Teilstrahlen 4a bis 4c (d) erzeugte hexagonale punktartige Interferenzstruktur (c) (I = Intensität).

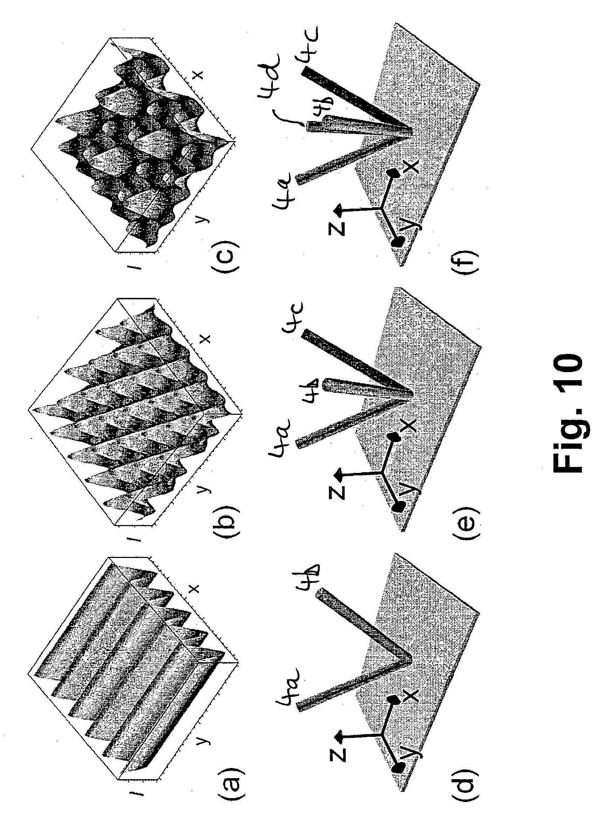

Fig. 10 zeigt ebenfalls Beispiele für Interferenzstrukturen durch Interferenz von zwei einzelnen Strahlen (d), von drei einzelnen Strahlen (e) oder von vier einzelnen Laserstrahlen (f): Durch Zwei-Strahl-Interferenz ergibt sich eine linienförmige Intensitätsverteilung I (a), durch Drei-Strahl-Interferenz bei symmetrischer Strahlkonfiguration die in Fig. 10 (b) gezeigte Interferenzstruktur mit Interferenzmaxima gleicher Intensität und durch Vier-Strahl-Interferenz mit der in (f) gezeigten Strahlkonfiguration eine Interferenzstruktur I mit Maxima unterschiedlicher Intensität (c).

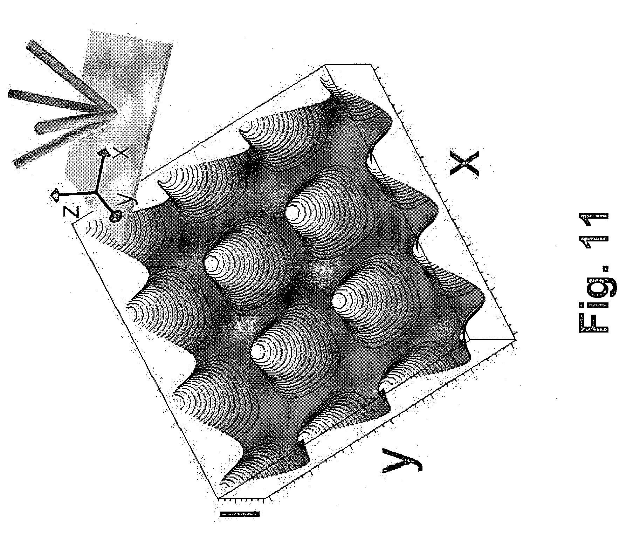

Fig. 11 zeigt ein weiteres Beispiel für eine Interferenzstruktur durch Vier-Strahl-Interferenz (I = Intensität; x und y bezeichnen zwei orthogonale Richtungen in der Schichtebene der TCF-Schicht bzw. tangential zur Oberfläche derselben).

Figur 12 zeigt einen schematischen Querschnitt senkrecht zur Schichtebene durch eine erfindungsgemäß hergestellte Tandem-Silizium-Dünnschichtsolarzelle (Die Tiefenstrukturierungen sind hier nur schematisch angedeutet): Der typische Schichtaufbau einer solchen Silizium-Dünnschicht-Solarzelle ist die p-i-n-Struktur: Das durch die beiden p- bzw. n-dotierten Schichten in der undotierten (intrinsischen) Si-Absorberschicht erzeugte elektrische Feld trennt die in der Absorberschicht durch Absorption des Sonnenlichts erzeugten Ladungsträger. Das hier verwendete Verfahren zum Aufbringen der a-Si:H-Schicht 6a ist ein PECVD-Prozess (plasmaunterstützte chemische Gasphasenabscheidung) bei Substrattemperaturen des Glases 2 zwischen 150 und 350 °C. Das Prozessgas Silan wird im Plasma aufgespalten, wodurch sich Si auf dem Substrat abscheidet. Die Dotierung erfolgt durch die Zugabe von phosphor- oder borhaltigen Gasen. Aufgrund der relativ geringen Beschichtungsraten von etwa 0.4 bis 0.8 µm/h für hochwertige a-Si:H-Absorberschichten 6a dauert die Herstellung einer typischerweise 0.3 µm dicken a-Si:H-Schicht etwa 30 Minuten. Mit einem PECVD-Verfahren können auch dünne mikrokristalline Silizium-Schichten 6b aus der Gasphase bei niedrigen Substrattemperaturen hergestellt werden, und dementsprechend sind hierzu dieselben Substrate und Fertigungskonzepte wie in der a-Si:H-Technologie anwendbar.

Auf diese Art und Weise wird erfindungsgemäß nach Ausbilden der Vertiefungen 5 zunächst eine erste, wasserstoffdotierte a-Si-Schicht 6a konformal in den Vertiefungen 5 sowie auf der verbliebenen TCF-Schicht abgeschieden, bevor dann, dem Konzept der Stapelzelle folgend, auf dieser Schicht 6a eine weitere Siliziumschicht aus mikrokristallinem Silizium 6b abgeschieden wird. Die p-i-n-Zellen werden durch diesen Herstellungsprozess bzw. durch das Stapeln automatisch elektrisch in Serie verschaltet - dieses Schema der Stapelzelle ist in Figur 12 gezeigt.

Als transparenter Frontkontakt bzw. als TCF-Schicht 3 dient hier transparentes und leitfähiges Metalloxid (also ein TCO, das Substrat ist hier Glas). Die Herstellung erfolgt über PECVD-Prozesse im Vakuum oder thermische CVD-Prozesse, übliche Materialien sind Indium-Zinn-Oxid, dotiertes Zinkoxid (z.B. ZnO:B, ZnO:Al) oder Zinnoxid (SnO₂:F). Der Rückkontakt 12 ist hier in Form einer TCO/Metall-Doppelschicht aufgebracht.

Die Bandlücke von a-Si beträgt üblicherweise 1,7 bis 1,8 eV, während mikrokristallines Silizium analog zum kristallinen Silizium eine indirekte Bandlücke von 1,1 eV besitzt. Diese indirekte Bandlücke und die darraus resultierenden kleinen Absorptionskoeffizienten für das langwellige Sonnenlicht erfordern effiziente Lichtfallen, die dafür sorgen, dass dieses Licht die Solarzelle mehrfach durchläuft und so trotz geringer Schichtdicken von 1 bis 3 µm noch effektiv absorbiert werden kann. Hierzu werden erfindungsgemäß die Vertiefungsstrukturen 5 eingebracht, beispielsweise in Form von Nanolöchern oder Nanosäulen, die dann vom abgeschiedenen a-Si:H und µc-Si:H umschlossen werden.

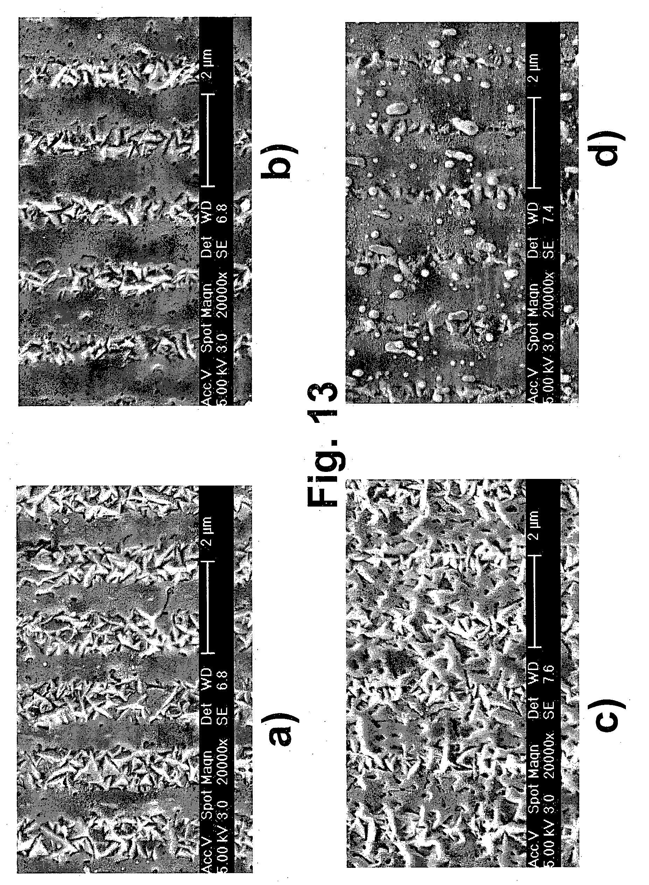

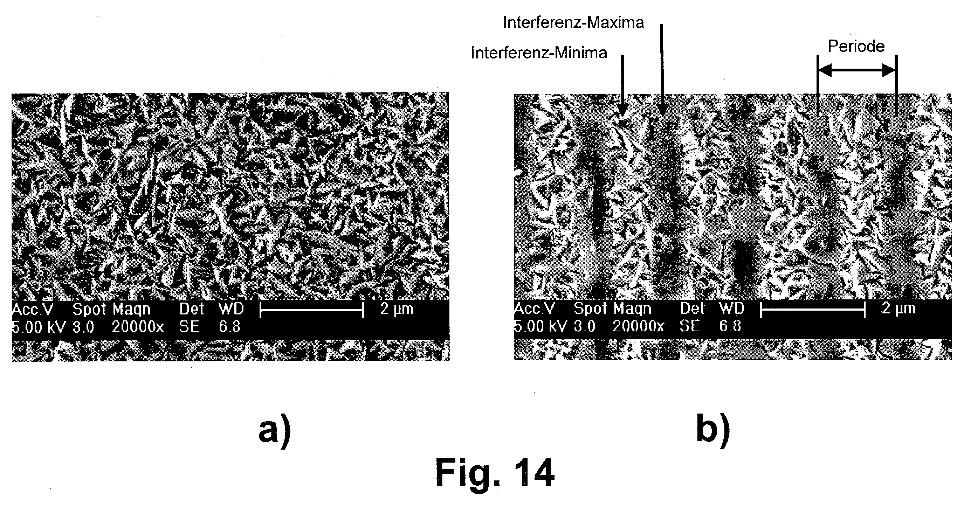

Fig. 13 und 14 zeigen Beispiele für Laserstrukturierungen gemäß der vorliegenden, auf der Interferenz-Methode basierten Erfindung.

Die Strukturierung kann mit unterschiedlichen Wellenlängen im UV-, im IR- oder im visuellen Bereich (beispielsweise 266 nm, 355 nm, 532 nm oder 1064 nm) erfolgen, indem ein oder mehrere Laserpulse mit Pulsdauern von einigen Femtosekunden bis hin zu einigen Nanosekunden verwendet werden. Die Laserfluenz (auftreffende Energie pro Flächeneinheit) jedes einzelnen Laserpulses kann beispielsweise im Bereich von einigen mJ/cm² bis hin zu mehreren J/cm² variiert werden. In den gezeigten Beispielen der Figuren 13 und 14 wurde ein gepulster 10 ns UV-Laser mit einer Wellenlänge von 355 nm verwendet, um die unterschiedlichen TCF-Schichten auf einem Glassubstrat 2 tiefenzustrukturieren 5, mit Energiedichten (Laserfluenz) zwischen 60 und 650 mJ/cm².

Alle Beispiele der strukturierten TCF-Schichten bestehen aus einer 1,6 µm dicken dotierten ZnO-Schicht 3 auf einem Glassubstrat 2. Ein linienförmiges Interferenzmuster zum Einstrukturieren einer Vielzahl von linear verlaufenden Gräben 5a, ... mit einem Periodenabstand p = d = 1,5 µm wird erzeugt (Vergleiche Figur 5).

Figur 13a: Laserfluenz (auf die TCF-Schicht 3 auftreffende Energie pro Flächeneinheit): 65 mJ/cm², ein Laserpuls, Pulsdauer: 10 ns.

Figur 13b: Laserfluenz: 65 mJ/cm², 10 Laserpulse, Pulsdauer: 10 ns.

Figuren 13c und 13d: abweichende Wellenlänge von 233 nm, Laserfluenz: 50 mJ/cm² (Figur 13c) und 400 mJ/cm² (Figur 13d), ein Laserpuls, Pulsdauer: 10 ns.

Figur 14a: unstrukturierte Probe, Figur 14b: tiefenstrukturierte Probe (Wellenlänge wieder 355 nm); Laserfluenz 65 mJ/cm², ein Laserpuls, Pulsdauer 10 ns. Gut zu sehen sind in Figur 14b die Gräben 5 an denjenigen Orten, an denen im Interferenzüberlagerungsmuster die ortsfesten Interferenzmaxima liegen, während an den dazwischen liegenden, ortsfesten Interferenzminima (Knotenpunkte der stehenden Überlagerungswelle) die Laserintensität niedriger als die Interferenzmaxima ist (evtl. auch Null)), das Material 3 also unverändert bleibt.

## Patentansprüche

1. Verfahren zur Herstellung eines elektrischen, photoelektrischen, elektrooptischen und/oder optischen Dünnschichtbauelementes (1),
wobei auf ein Substrat (2) mindestens eine als erster elektrischer Kontakt des Dünnschichtbauelements geeignete, optisch transparente, elektrisch leitfähige Schicht (TCF-Schicht, 3) aufgebracht wird, bevorzugt abgeschieden wird,
wobei auf und/oder in die mindestens eine TCF-Schicht (3) Laserlicht (4) so eingestrahlt wird, dass hierdurch in ihr (3) ein Intensitätseintrag bewirkt wird und durch diesen Intensitätseintrag in ihr (3) durch Materialabtrag eine Vielzahl von Vertiefungen (5a, 5b, ...) ausgebildet werden, und
wobei in und auf diese(n) so ausgebildeten Vertiefungen (5a, 5b, ...) mindestens ein zur Ausbildung eines elektrischen, photoelektrischen, elektrooptischen und/oder optischen Effektes geeignetes Material (6) eingebracht oder aufgebracht wird, bevorzugt abgeschieden wird, ***dadurch gekennzeichnet, dass***
die Laserlichteinstrahlung erfolgt, indem mehrere kohärente Laserstrahlen (4a, 4b, ...) in einem Überlagerungsbereich (U) unter vordefinierten Winkeln zur Interferenz gebracht werden und indem die mindestens eine TCF-Schicht (3) an einer vordefinierten Position in diesem Überlagerungsbereich (U) positioniert wird, wobei bevorzugt die mehreren Laserstrahlen (4a, 4b, ...) mittels mindestens eines Strahlteilers (10a, 10b, ...) aus einem einzelnen, von einem Laser emittierten Laserstrahl (4) erzeugt und unter Verwendung mindestens eines Strahlumlenkers (11a, 11b, ...) in den Überlagerungsbereich (U) geführt werden.

2. Verfahren nach dem vorhergehenden Anspruch,
***dadurch gekennzeichnet, dass***
die Laserlichteinstrahlung (4) mit in der Schichtebene (7) des Dünnschichtbauelementes (1) gesehen örtlich variierender Laserlichtintensität erfolgt und dass dadurch in dieser Schichtebene (7) gesehen ein örtlich variierender Materialabtrag zur Ausbildung der Vertiefungen (5a, 5b, ...) erfolgt.

3. Verfahren nach den vorhergehenden Ansprüchen,
**dadurch gekennzeichnet**,_dass das Laserlicht (4) in das Innere der mindestens einen TCF-Schicht (3) eingestrahlt wird, bevorzugt fokussiert wird.

4. Verfahren nach einem der vorhergehenden Ansprüche,
***dadurch gekennzeichnet, dass***
die Vielzahl von Vertiefungen (5a, 5b, ...) in Form einer in der Schichtebene (7) des Dünnschichtbauelements (1) periodischen Vertiefungsstruktur (5), insbesondere einer in dieser Schichtebene (7) in einer Richtung (R1) periodisch ausgebildeten Vertiefungsstruktur (5) oder einer in zwei zueinander unter einem Winkel (α) von ungleich 0°, bevorzugt von 90°, stehenden Richtungen (R1, R2) periodisch ausgebildeten Vertiefungsstruktur (5), ausgebildet wird.

5. Verfahren nach einem der vorhergehenden Ansprüche **dadurch gekennzeichnet, dass** die Vielzahl von Vertiefungen (5a, 5b, ...) so ausgebildet wird, dass der Abstand d (d1, d2) benachbarter Vertiefungen (5a, 5b, ...) und/oder eine Periodizität p der Vertiefungsstruktur (5) in der Schichtebene (7) des Dünnschichtbauelements (1) zwischen 100 nm und 500 µm, bevorzugt zwischen 0,5 µm und 5 µm, beträgt/betragen, dass die Tiefenausdehnung h der Vertiefungen (5a, 5b, ...) senkrecht zu dieser Schichtebene (7) zwischen 10 nm und 50 µm, bevorzugt zwischen 300 nm und 10 µm, beträgt, dass die laterale Ausdehnung *l* der Vertiefungen (5a, 5b, ...) in der Schichtebene (7) des Dünnschichtbauelements (1) zwischen 25 nm und 250 µm, bevorzugt zwischen 250 nm und 10 µm, beträgt, und/oder dass das Aspektverhältnis *A=h*/*l* von vorstehender Tiefenausdehnung h und vorstehender lateraler Ausdehnung *l* zwischen 0.05 und 10, bevorzugt zwischen 0.3 und 3 liegt. und/oder
dadurch, dass die mindestens eine TCF-Schicht (3), insbesondere eine tiefenzustrukturierende (5) TLC-Schicht (3) mit einer Schichtdicke zwischen 50 nm und 200 µm, insbesondere zwischen 200 nm und 5 µm, aufgebracht wird.

6. Verfahren nach dem vorhergehenden Anspruch,
***dadurch gekennzeichnet, dass***
die Vielzahl von Vertiefungen (5a, 5b, ...) so ausgebildet wird, dass die periodische Vertiefungsstruktur (5) eine Vielzahl einzelner, linienförmiger, parallel zueinander und jeweils mit konstantem Grabenabstand (d, d1) voneinander verlaufende Gräben umfassende Grabenstruktur (G1) oder eine zwei solche sich unter einem Winkel (α) von ungleich 0°, bevorzugt von 60°, kreuzende Grabenstrukturen (G1, G2) mit gleichen oder unterschiedlichen Grabenabständen (d1, d2) aufweisende Struktur umfasst.

7. Verfahren nach einem der vorhergehenden Ansprüche, **dadurch gekennzeichnet, dass** die Vielzahl von Vertiefungen (5a, 5b, ...) so ausgebildet wird, dass die periodische Vertiefungsstruktur (5) eine Vielzahl von Löchern (LO) aufweisende, periodische Lochstruktur umfasst, wobei bevorzugt die Löcher (LO) dieser Lochstruktur in zwei zueinander unter einem Winkel (α) von ungleich 0°, bevorzugt von zwischen 45° und 90° einschließlich der Grenzen von 45° und 90°, stehenden Richtungen (R1, R2) jeweils in periodischen Abständen (d1, d2) ausgebildet sind.

8. Verfahren nach einem der vorhergehenden Ansprüche,
***dadurch gekennzeichnet, dass***
als Dünnschichtbauelement (1) eine CuInSe₂-basierte Dünnschichtsolarzelle (CIS-Solarzelle), eine Cu (In, Ga) (S, Se)₂-basierte Dünnschichtsolarzelle (CIGS-Solarzelle), eine Dünnschichtsolarzelle auf Basis organischer Halbleiter, eine Dünnschichtsolarzelle auf Basis von bevorzugt wasserstoffdotiertem amorphen a-Si oder mikrokristallinem µ-Si Silizium, eine Dünnschichtsolarzelle auf Basis von GaAs oder CdTe oder lichtemittierende Elemente hergestellt wird.

9. Verfahren nach mindestens einem der vorhergehenden Ansprüche, **dadurch gekennzeichnet, dass** die mindestens eine TCF-Schicht (3) mindestens ein transparentes, leitfähiges Oxid (TCO), bevorzugt indiumdotiertes Zinnoxid (ITO), fluordotiertes Zinnoxid (FTO) oder dotiertes Zinkoxid, oder mindestens ein transparentes und leitfähiges Polymer, bevorzugt PEDOT oder PEDOT:PSS, oder ein Kohlenstoff-Nanoröhren-Netzwerk enthält oder daraus besteht,

10. Verfahren nach einem der vorhergehenden Ansprüche, **dadurch gekennzeichnet, dass** der elektrische, photoelektrische, elektrooptische und/oder optische Effekt eine Absorption elektromagnetischer Strahlung, insbesondere im Bereich des sichtbaren Lichts, und Umwandlung dieser Strahlung in elektrische Ladungsträger oder eine Umwandlung von Energie elektrischer Ladungsträger, bevorzugt durch Rekombination solcher Ladungsträger, in elektromagnetische Strahlung, insbesondere im Bereich des sichtbaren Lichts, ist.

11. Verfahren nach einem der vorhergehenden Ansprüche, **dadurch gekennzeichnet, dass** das Material (6) CuInSe₂, Cu (In, Ga) (S, Se)₂, a-Si, bevorzugt a-Si:H, µ-Si, bevorzugt µ-Si:H, GaAs oder CdTe enthält oder daraus besteht, oder dass das Material (6) ein organo-metallisches Chelat, bevorzugt Alq3, oder mindestens ein elektrolumineszentes, elektrisch leitfähiges Polymer enthält oder daraus besteht.

12. Verfahren nach einem der vorhergehenden Ansprüche, **dadurch gekennzeichnet, dass** die mindestens eine TCF-Schicht (3) im sichtbaren Wellenlängenbereich, im Infrarot-Wellenlängenbereich und/oder im Ultraviolett-Welllenlängenbereich optisch transparent ist.

13. Verfahren nach einem der vorhergehenden Ansprüche, **dadurch gekennzeichnet, dass** das Substrat flexibel oder starr ist und/oder Glas oder Kunststoff enthält oder daraus besteht.

14. Verfahren nach einem der vorhergehenden Ansprüche,
***dadurch gekennzeichnet, dass***
auf die mindestens eine TCF-Schicht (3), deren Vertiefungen (5a, 5b, ...) und/oder mindestens einem der Materialien (6) ein zweiter elektrischer Kontakt des Dünnschichtbauelements, insbesondere ein Rückseitenkontakt (12), angebracht oder aufgebracht wird, bevorzugt abgeschieden wird, wobei die vorbeschriebene Ausbildung des zweiten elektrischen Kontakts so erfolgt, dass dieser Kontakt von der/den TCF-Schicht(en) elektrisch isoliert ist.

15. Verfahren nach einem der vorhergehenden Ansprüche,
***dadurch gekennzeichnet, dass***
die Laserbestrahlung gepulst oder kontinuierlich und/oder mit mindestens einer Laserwellenlänge im sichtbaren, im infraroten und/oder im ultravioletten Bereich, bevorzugt mit Laserlicht eines Nd:YAG gepulsten Lasers der Wellenlänge 266 nm und 355 nm, erfolgt.

## Claims

1. Method for fabricating an electric, photoelectric, electro-optical and/or optical thin-film component (1),
wherein at least one optically transparent, electrically conductive film (TCF film 3) which is suitable as a first electric contact of the thin-film component is applied to, preferably deposited on a substrate (2), wherein laser light (4) is irradiated onto and/or into the at least one TCF film (3) in such a manner that said TCF film (3) is charged with a certain intensity such that a plurality of depressions (5a, 5b ...) are thereby formed in said TCF film (3) as material is removed, and wherein at least one material (6) suitable to generate an electric, photoelectric, electro-optical and/or optical effect is introduced into or applied to, preferably deposited on the thusly formed depression(s) (5a, 5b, ...)
**characterized in that**
the laser light irradiation is performed by causing several coherent laser beams (4a, 4b, ...) to interfere in an interference region (U) at predefined angles and by positioning the at least one TCF film (3) at a predefined position in said interference region (U), wherein preferably the several laser beams (4a, 4b, ...) are created by means of at least one beam divider (10a, 10b, ...) from an individual laser beam (4) which is emitted by a laser and are guided into the interference region (U) using at least one beam deflector (11a, 11b, ...).

2. Method according to the preceding claim,
**characterized in that**
the laser light irradiation (4) takes place with a locally varying laser light intensity, seen in the film plane (7) of the thin-film component (1), thereby causing, seen in said film plane (7), a locally varying material removal to form the depressions (5a, 5b, ...).

3. Method according to the preceding claims,
**characterized in that**
the laser light (4) is irradiated, preferably focused into the interior of the at least one TCF film (3).

4. Method according to one of the preceding claims,
**characterized in that**
the plurality of depressions (5a, 5b, ...) are created in the form of a depression structure which is periodic in the film plane (7) of the thin-film component (1), in particular a depression structure (5) which is periodically formed in said film plane (7) in a direction (R1), or a depression structure (5) which is periodically formed in two directions (R1, R2) running at an angle (α) of unequal 0°, preferably 90° with respect to one another.

5. Method according to one of the preceding claims,
**characterized in that**
the plurality of depressions (5a, 5b, ...) are formed such that the distance d (d1, d2) of adjacent depressions (5a, 5b, ...) and/or a periodicity *p* of the depression structure (5) in the film plane (7) of the thin-film component (1) lies/lie between 100 nm and 500 µm, preferably between 0.5 µm and 5 µm, the depth extension h of the depressions (5a, 5b, ...) perpendicular to said film plane (7) lies between 10 nm and 50 µm, preferably between 300 nm and 10 µm, the lateral extension / of the depressions (5a, 5b, ...) in the film plane (7) of the thin-film component (1) lies between 25 nm and 250 µm, preferably between 250 nm and 10 µm, and/or the aspect ratio *A=h*/*l* of the aforesaid depth extension h and the aforesaid lateral extension *l* lies between 0.05 and 10, preferably between 0.3 and 3, and/or **in that** the at least one TCF film (3), in particular a TLC film (3) to be deep-structured with a film thickness between 50 nm and 200 µm, in particular between 200 nm and 5 µm, is applied.

6. Method according to one of the preceding claims,
**characterized in that**
the plurality of depressions (5a, 5b, ...) are formed such that the periodic depression structure (5) comprises a ditch structure (G1) including a plurality of individual, linear ditches which are arranged in parallel to one another and each extend at a constant ditch distance (d, d1) from one another, or comprises a structure which has two of such ditch structures (G1, G2) which cross each other at an angle (α) of unequal 0°, preferably 60°, at identical or different ditch distances (d1, d2).

7. Method according to one of the preceding claims,
**characterized in that**
the plurality of depressions (5a, 5b, ...) are designed such that the periodic depression structure (5) comprises a periodic hole structure having a plurality of holes (LO), wherein preferably the holes (LO) of said hole structure are each formed at periodic distances (d1, d2) in two directions (R1, R2) running at an angle (α) of unequal 0° with respect to one another, preferably between 45° and 90°, including the boundaries of 45° and 90°.

8. Method according to one of the preceding claims,
**characterized in that**
the thin-film component (1) is formed as a CuInSe₂-based thin-film solar cell (CIS solar cell), a Cu (In, Ga) (S, Se)₂-based thin-film solar cell (CIGS solar cell), a thin-film solar cell based on organic semiconductors, a thin-film solar cell preferably based on hydrogen-doped amorphous a-Si or microcrystalline µ-Si silicon, a thin-film solar cell based on GaAs or CdTe or light-emitting elements.

9. Method according to at least one of the preceding claims,
**characterized in that**
the at least one TCF film (3) comprises or is composed of at least one transparent, conductive oxide (TCO), preferably indium-doped tin oxide (ITO), fluorine-doped tin oxide (FTO) or doped zinc oxide, or at least one transparent and conductive polymer, preferably PEDOT or PEDOT:PSS, or a carbon nanotube network.

10. Method according to one of the preceding claims,
**characterized in that**
the electric, photoelectric, electro-optical and/or optical effect is an absorption of electromagnetic radiation, in particular in the range of visible light, and a conversion of said radiation into electric charge carriers or a conversion of energy of electric charge carriers, preferably by recombination of such charge carriers, into electromagnetic radiation, in particular in the range of visible light.

11. Method according to one of the preceding claims,
**characterized in that**
the material (6) comprises or is composed of CuInSe₂, Cu (In, Ga) (S, Se)₂, preferably a-Si:H, µ-Si, preferably µ-Si:H, GaAs or CdTe, or **in that** the material (6) comprises or is composed of an organometallic chelate, preferably Alq3 or at least one electroluminescent, electrically conductive polymer.

12. Method according to one of the preceding claims,
**characterized in that**
the at least one TCF film (3) is optically transparent in the visible wavelength range, the infrared wavelength range and/or the ultraviolet wavelength range.

13. Method according to one of the preceding claims,
**characterized in that**
the substrate is flexible or rigid and/or comprises or is composed of glass or plastic material.

14. Method according to one of the preceding claims,
**characterized in that**
a second electric contact of the thin-film component, in particular a backside contact (12), is attached or applied to, preferably deposited on the at least one TCF film (3), the depressions (5a, 5b, ...) thereof and/or at least one of the materials (6), wherein the above-mentioned formation of the second electric contact takes place in such a manner that said contact is electrically insulated from the TCF film(s).

15. Method according to one of the preceding claims,
**characterized in that**
the laser irradiation takes place in a pulsed or continuous manner and/or with at least one laser wavelength in the visible, infrared and/or ultraviolet range, preferably with laser light of an Nd:YAG pulsed laser of wavelength 266 nm and 355 nm.

## Revendications

1. Procédé de fabrication d'un composant à couches minces (1) électrique, photoélectrique, électro-optique et/ou optique,
au moins une couche électro-conductrice (couche TCF, 3), optiquement transparente, adaptée en tant que premier contact électrique du composant à couches minces, étant appliquée sur un substrat (2),
une lumière laser (4) étant appliquée sur et/ou dans l'au moins une couche TCF (3), de façon à provoquer dans celle-ci (3) un apport d'intensité et, cet apport d'intensité permettant de réaliser dans celle-ci (3), par enlèvement de matière, une pluralité de creux (5a, 5b, ...) et
au moins un matériau (6) adapté à la réalisation d'un effet électrique, photoélectrique, électro-optique et/ou optique étant introduit ou appliqué, de préférence déposé, dans et sur ce(s) creux (5a, 5b, ...) ainsi réalisé(s)
**caractérisé en ce que**
l'irradiation laser a lieu grâce au fait que plusieurs rayons lasers cohérents (4a, 4b, ...) sont amenés en interférence dans une zone de superposition (U) sous différents angles et grâce au fait que l'au moins une couche TCF (3) est positionnée à une position prédéfinie dans cette zone de superposition, les plusieurs rayons laser (4a, 4b, ...) étant générés de préférence au moyen d'au moins un diviseur de faisceau (10a, 10b, ...) à partir d'un rayon laser (4) émis par un laser et guidés, à l'aide d'au moins un déflecteur de faisceau (11a, 11b, ...), vers la zone de superposition (U).

2. Procédé selon la revendication précédente, **caractérisé en ce que** l'irradiation laser (4) a lieu avec une intensité de lumière laser variable localement, vue dans le niveau de la couche (7) du composant à couches minces (1) et **en ce que**, vu dans ce niveau de couche (7), un enlèvement de matière variable localement a lieu pour la réalisation des creux (5a, 5b, ...).

3. Procédé selon les revendications précédentes, **caractérisé en ce que** la lumière laser (4) est irradiée, de préférence focalisée, à l'intérieur de l'au moins une couche TCF (3).

4. Procédé selon l'une des revendications précédentes, **caractérisé en ce que** la pluralité de creux (5a, 5b, ...) sont réalisés sous la forme d'une structure de creux (5) périodique dans le niveau de couche (7) du composant à couches minces (1), plus particulièrement sous la forme d'une structure de creux (5) réalisée de manière périodique dans ce niveau de couche (7) dans une direction (R1) ou d'une structure de creux (5) réalisée de manière périodique dans deux directions (R1, R2) formant entre elles un angle (α) différent de 0°, de préférence égal à 90°.

5. Procédé selon l'une des revendications précédentes, **caractérisé en ce que** la pluralité de creux (5a, 5b, ...) est conçue de façon à ce que la distance d (d1, d2) entre des creux adjacents (5a, 5b, ...) et/ou une périodicité p de la structure de creux (5) dans le niveau de couche (7) du composant à couches minces (1) sont entre 100 nm et 500 µm, de préférence entre 0,5 µm et 5 µm, **en ce que** l'extension en profondeur h des creux (5a, 5b, ...) perpendiculairement à ce niveau de couche (7) est entre 10 nm et 50 µm, de préférence entre 300 nm et 10 µm, **en ce que** l'extension latérale I des creux (5a, 5b, ...) dans le niveau de couche (7) du composant à couches minces (1) est entre 25 nm et 250 µm, de préférence entre 250 nm et 10 µm, et/ou **en ce que** le rapport d'aspect A=h/l entre l'extension en profondeur h précédente et l'extension latérale l précédente est entre 0,05 et 10, de préférence entre 0,3 et 3 et/ou **en ce que** l'au moins une couche TCF (3), plus particulièrement une couche TLC (3) à structurer en profondeur (5) avec une épaisseur de couche entre 50 nm et 200 µm, plus particulièrement entre 200 nm et 5 µm, est appliquée.

6. Procédé selon la revendication précédente, **caractérisé en ce que** la pluralité de creux (5a, 5b, ...) sont réalisés de façon à ce que la structure de creux périodique (5) comprenne une structure de tranchées (G1) comprenant une pluralité de tranchées s'étendant linéairement, parallèlement entre elles et avec une distance constante (d, d1) entre elles ou une structure comprenant deux de ces structures de tranchées (G1, G2) se croisant avec un angle (α) différent de 0°, de préférence égal à 60°, avec les mêmes distances ou des distances différentes entre les tranchées (d1, d2).

7. Procédé selon l'une des revendications précédentes, **caractérisé en ce que** la pluralité de creux (5a, 5b, ...) sont conçus de façon à ce que la structure de creux périodique (5) comprenne une structure de trous périodique comprenant une pluralité de trous (LO), les trous (LO) de cette structure de trous étant réalisés de préférence dans deux directions (R1, R2) formant entre elles un angle (α) différent de 0°, de préférence entre 45° et 90°, les limites de 45° et 90° étant incluses, à des intervalles périodiques (d1, d2).

8. Procédé selon les revendications précédentes, **caractérisé en ce que**, en tant que composant à couches minces (1), une cellule photovoltaïque à couches minces à base de CuInSe₂ (cellule photovoltaïque CIS), une cellule photovoltaïque à couches minces à base de Cu (In, Ga) (S, Se)₂, une cellule photovoltaïque à couches minces à base de semi-conducteur organique, une cellule photovoltaïque à couches minces à base de préférence de silicium amorphe a-Si dopé avec de l'hydrogène ou de silicium micro-cristallin µ-Si, une cellule photovoltaïque à couches minces à base de GaAs ou de CdTe ou des éléments luminescents sont réalisés.

9. Procédé selon au moins l'une des revendications précédentes, **caractérisé en ce que** l'au moins une couche TCF (3) contient ou est constituée d'au moins un oxyde transparent conducteur (TCO), de préférence de l'oxyde d'étain dopé avec de l'indium (ITO), de l'oxyde d'étain dopé avec du fluor (FTO) ou de l'oxyde de zinc dopé ou au moins un polymère transparent et conducteur, de préférence du PEDOT ou du PEDOT:PSS ou un réseau de nanotubes de carbone.

10. Procédé selon au moins l'une des revendications précédentes, **caractérisé en ce que** l'effet électrique, photoélectrique, électro-optique et/ou optique est une absorption de rayonnement électromagnétique, plus particulièrement dans le domaine de la lumière visible, et une conversion de ce rayonnement en porteurs de charges électriques ou une conversion de l'énergie des porteurs de charges électriques, de préférence par recombinaison de ces porteurs de charges, en un rayonnement électromagnétique, plus particulièrement dans le domaine de la lumière visible.

11. Procédé selon au moins l'une des revendications précédentes, **caractérisé en ce que** le matériau (6) contient ou est constitué de CuInSe2, de Cu(In, Ga) (S, Se)2, de a-Si, de µ-Si, de préférence de µ-Si:H, de GaAs ou de CdTe ou **en ce que** le matériau (6) est un chélate organométallique, de préférence de l'Alq3 ou contient ou est constitué d'au moins un polymère transparent électro-conducteur.

12. Procédé selon au moins l'une des revendications précédentes, **caractérisé en ce que** l'au moins une couche TCF est optiquement transparente dans le domaine des longueurs d'ondes visibles, dans le domaine de longueurs d'ondes de l'infrarouge et/ou dans le domaine de longueurs d'ondes de l'ultraviolet.

13. Procédé selon au moins l'une des revendications précédentes, **caractérisé en ce que** le substrat est flexible ou rigide et/ou contient ou est constitué de verre ou d'une matière plastique.

14. Procédé selon au moins l'une des revendications précédentes, **caractérisé en ce que**, sur l'au moins une couche TCF (3), ses creux (5a, 5b, ...) et/ou au moins un des matériaux (6), est appliqué ou apposé, de préférence déposé, un deuxième contact électrique du composant à couches minces, plus particulièrement un contact arrière (12), la réalisation, décrite ci-dessus, du deuxième contact électrique ayant lieu de façon à ce que ce contact soit isolé électriquement de la ou des couche(s) TCF.

15. Procédé selon au moins l'une des revendications précédentes, **caractérisé en ce que** l'irradiation laser a lieu de manière pulsée ou continue et/ou avec au moins une longueur d'onde de laser dans le domaine visible, infrarouge et/ou ultraviolet, de préférence avec une lumière provenant d'un laser pulsé Nd:YAG d'une longueur d'onde de 266 nm et 355 nm.
